# EUROPÄISCHE PATENTSCHRIFT

(11) **EP 2 602 935 B1**
(45) Veröffentlichungstag und Bekanntmachung des Hinweises auf die Patenterteilung: **20.06.2018**
(21) Anmeldenummer: 11191889.2
(22) Anmeldetag: 05.12.2011
(51) Int. Cl.: H03K 17/945, H03K 17/97

(54) **Sensoranordnung**
Sensor assembly
Dispositif de détection

(43) Veröffentlichungstag der Anmeldung: 12.06.2013
(73) Patentinhaber: Baumer Electric AG, 8501 Frauenfeld (CH)
(72) Erfinder: Brändle, Daniel, 8500 Frauenfeld (CH); Reetmeyer, Burkhard, 78465 Konstanz (DE)
(74) Vertreter: Strauss, Steffen

(56) Entgegenhaltungen:
- DE-C1- 19 602 681
- US-A- 3 718 882
- US-A- 5 648 719

## Beschreibung

Die vorliegende Erfindung betrifft eine Sensoranordnung gemäß dem Oberbegriff des Anspruches 1.

Sensoren werden für unterschiedliche technische Anwendungen eingesetzt. Optische, kapazitive oder induktive Sensoren werden beispielsweise als Nährungsschalter, Füllstandsensoren und Drehgeber eingesetzt. Ein induktiver Sensor weist beispielsweise einen elektrischen Schwingkreis mit einer Spule und einem Kondensator auf sowie einer Anregungseinheit. Mittels der Anregungseinheit wird der elektrische Schwingkreis in eine elektromagnetische Schwingung versetzt. Von einer Elektronik kann eine Änderung eines Parameters des elektrischen Schwingkreises ausgewertet werden. Dadurch können beispielsweise ferromagnetische bzw. metallische Gegenstände in der Nähe des elektrischen Schwingkreises erfasst werden. In einigen Anwendungen ist eine Kalibrierung des Sensors mit Hilfe eines sogenannten Teach-In-Verfahrens erforderlich. Bei einer Kalibrierung bzw. einem Teach-In-Verfahren wird beispielsweise eingestellt, innerhalb welchen Abstandes eines zu erfassenden Gegenstandes zu dem induktiven Sensor ein Schalter des induktiven Sensors geöffnet bzw. geschlossen ist. Hierzu ist es erforderlich, einen Informationsaustausch mit dem Sensor und einer Elektronik des Sensors auszuführen. Dies wird im Allgemeinen mit einem sogenannten Teach-In-Element und einer optischen Anzeigeeinrichtung ausgeführt. Das Teach-In-Element ist als ein Schalter oder ein Potentiometer ausgeführt. Das Teach-In-Element bildet somit eine Schnittstelle zur Kalibrierung des Sensors. Mit der optischen Anzeigeeinrichtung wird im Allgemeinen ein Teach-In-Zustand angezeigt. Dadurch kann an dem Sensor mit der Elektronik eingegeben bzw. einprogrammiert werden, innerhalb welches Abstandes des zu erfassenden Gegenstandes der Schalter des Sensors geschlossen und außerhalb welchen Abstandes der Schalter geöffnet ist.

Sensoren mit einer entsprechenden Elektronik werden häufig in rauen Umgebungsbedingungen eingesetzt. Hierzu ist es erforderlich, den Sensor zum mechanischen und / oder hydraulischen Schutz vor der Umgebung abzukapseln. Das Teach-In-Element des Sensors ist dabei von außerhalb des Gehäuses zu betätigen, so dass es erforderlich ist, in aufwendiger Weise im Allgemeinen Stromleitungen von außerhalb des Gehäuses an dem Teach-In-Element nach innerhalb des Gehäuses zu dem Sensor zu führen. Eine derartige Durchführung von Stromleitungen durch das Gehäuse ist jedoch aufwendig und kostspielig. Das Gehäuse muss entsprechend mit einer Öffnung versehen sein und diese Öffnungen sind bei der Herstellung des Sensors bezüglich der Umgebung abzudichten, damit ein hydraulisch dichtes Gehäuse zur Verfügung steht. Dadurch fallen bei der Herstellung große Kosten an.

Aus der DE 100 25 662 B4 ist ein Näherungssensor mit einem Oszillator bekannt. Eine Auswerteeinrichtung dient zur Erzeugung eines analogen Ausgangssignals in Abhängigkeit eines Messabstands zwischen einem Gegenstand und dem Oszillator. Eine Schaltpunkt-Auswerteeinheit stellt ein digitales Ausgangssignal zur Verfügung. Die Schaltpunkt-Auswerteeinheit kann mit einer internen oder externen Tastatur verbunden werden. Der Gegenstand wird in einem vorgesehenen Schaltabstand von dem Oszillator positioniert und dann dieser Schaltabstand gespeichert. Dadurch ist der Schaltpunkt bezüglich eines vorgegebenen Schaltabstandes eingestellt.

Aus der WO 2009 027 455 ist eine Sensoranordnung für eine berührungslose Einstellung von Sensorparametern bekannt. Innerhalb eines Gehäuses der Sensoranordnung ist hierbei sowohl der Sensor als auch ein Zusatzsensor als Teach-In-Element angeordnet. Der Zusatzsensor ist dabei als ein induktiver Sensor ausgebildet. Mittels eines Handhabungswerkzeuges außerhalb des Gehäuses als Target, z. B. einem Schraubendreher, kann der induktive Sensor als Zusatzsensor bzw. Teach-In-Element ein- und ausgeschaltet werden. Der Anwender dieser Sensoranordnung ist dadurch angehalten, ein gesondertes Handhabungswerkzeug, z. B. einen Schraubendreher, zur Kalibrierung der Sensoranordnung und Betätigung des Teach-In-Elements in aufwendiger Weise vorzuhalten. Zudem muss das Handhabungswerkzeug besondere Anforderungen hinsichtlich Grösse und Material erfüllen. Zudem ist für eine funktionssichere Handhabung eine definierte Annäherung des Handhabungswerkzeuges erforderlich, was in Abhängigkeit der Einbausituation der Sensoranordnung nicht immer gewährleistet werden kann.

Aus der DE 196 02 681 C1 ist eine weitere Sensoranordnung mit berührungsloser Einstellung und Parametrierung mittels eines Teach-In-Elements bekannt. Die Aufgabe der vorliegenden Erfindung besteht deshalb darin, eine Sensoranordnung zur Verfügung zu stellen, die die aufgezeigten Nachteile im Stand der Technik überwindet.

Diese Aufgabe wird gelöst mit einer Sensoranordnung, umfassend: ein Gehäuse einen Sensor, einen Zusatzsensor und ein Target. Der Sensor oder ein Teil des Sensors ist innerhalb des Gehäuses angeordnet. Der Zusatzsensor ist innerhalb des Gehäuses angeordnet und als Teach-In-Element zur berührungslosen Kalibrierung des Sensors ausgebildet. Das Target ist außerhalb des Gehäuses bewegbar ausgeführt und mit dem Gehäuse verbunden, so dass mit dem Target der Zusatzsensor als Teach-In-Element mittels einer Bewegung des Targets betätigbar ist.

Der Sensor und der Zusatzsensor als Teach-In-Element sind vorzugsweise als gesonderte Bauteile ausgebildet. Vorzugsweise ist das Target zwischen wenigstens zwei definierten Positionen bewegbar ausgeführt, so dass in einer ersten Position des Targets mittels des Teach-In-Elements ein erster Schaltzustand realisierbar ist und in einer zweiten Position des Targets ein zweiter Schaltzustand realisierbar ist, wobei die Schaltzustände zur Kalibrierung des Sensors verwendbar sind.

Der Anwender der Sensoranordnung braucht damit zur Betätigung des Zusatzsensors als Teach-In-Element innerhalb des Gehäuses kein gesondertes Target, z.B. einen Schraubendreher, außerhalb des Gehäuses vorzuhalten. Die Kalibrierung bzw. das Teach-In-Verfahren der Sensoranordnung kann dadurch in der praktischen Anwendung wesentlich vereinfacht werden. Außerdem kann dadurch der Zusatzsensor als Teach-In-Element zuverlässiger betätigt werden, weil bei einem Target, welches von dem Anwender zur Verfügung gestellt wird, die Eigenschaften dieses Targets nicht eindeutig definiert sind, beispielsweise welche Wirbelströme an einem Schraubendreher bei einem Zusatzsensor als induktiven Sensor im welchem Umfang ausgelöst werden. Das Target stellt ein, vorzugsweise mechanisches, Betätigungsorgan für den Zusatzsensor dar.

Das Target kann mit einer form- und / oder stoff- und / oder kraftschlüssigen Verbindung mit dem Gehäuse verbunden sein. Die Verbindung des Targets mit dem Gehäuse kann dabei mittelbar oder unmittelbar ausgeführt sein.

Bei einer mittelbaren Verbindung des Targets mit dem Gehäuse ist das Target mit einem weiteren Gegenstand, z. B. einem Befestigungsteil, mit dem Gehäuse verbunden und der weitere Gegenstand ist vorzugsweise Bestandteil der Sensoranordnung.

Das Befestigungsteil kann jeweils mit dem Gehäuse unlösbar verbunden, so dass dadurch das Target Bestandteil der Sensoranordnung ist.

In einer festen Verbindung von Target und Gehäuse ist das Target mittels Umspritzung und / oder einer Klebung mit dem Gehäuse verbunden. Auch mittels einer Umspritzung oder einer Klebung, d.h. bei einer Umspritzung bei Herstellung des Gehäuses in einem Kunststoffspritzgusswerkzeug aus thermoplastischem Kunststoff, kann das Target besonders einfach mit dem Gehäuse verbunden werden.

Zweckmäßig ist das Gehäuse fluiddicht ausgebildet und/oder das Gehäuse weist keine Öffnung auf und/oder das Gehäuse umfasst einen Verschlussdeckel. Das Gehäuse ermöglicht dadurch den Zusatzsensor oder den Teil des Zusatzsensors innerhalb des Gehäuses sowie den Sensor thermisch, mechanisch und hydraulisch bezüglich der Umgebung zu isolieren. Beim Einsatz der Sensoranordnung in schlechten Umgebungsbedingungen ist dadurch ein ausreichender Schutz des Sensors und des Zusatzsensors innerhalb des Gehäuses gewährleistet. Da eine Betätigung des Zusatzsensors innerhalb des Gehäuses berührungslos von außerhalb mittels des Targets möglich ist, ist es auch nicht erforderlich, eine aufwendige fluiddichte Durchführung von Stromkabeln durch das Gehäuse auszuführen.

In einer weiteren Ausführungsform ist das Gehäuse im Bereich zwischen dem Target und dem Zusatzsensor einteilig ohne eine Öffnung ausgebildet, da keine Stromkabel zwischen dem äußeren Betätigungsorgan, nämlich dem Target, und dem Zusatzsensor innerhalb des Gehäuses erforderlich sind, Das Gehäuse kann dadurch besonders preiswert hergestellt werden.

Das Target kann ein biegbares Federelement sein und vorzugsweise wenigstens teilweise aus einem ferromagnetischen Material bestehen. Zweckmäßig befindet sich das biegbare Federelement beim Aufbringen einer Druckkraft in eine erste Schaltstellung. Beim Entfernen dieser Druckkraft bewegt sich das biegbare Federelement selbständig in eine zweite Schaltstellung. Dadurch kann das Teach-In-Element besonders einfach von außen betätigt werden, indem entweder eine oder keine Druckkraft auf das biegbare Federelement aufgebracht wird.

In einer alternativen Ausgestaltung der erfindungsgemässen Sensoranordnung kann das Target als ein Permanentmagnet ausgeführt sein. Vorzugsweise ist der Permanentmagnet mittelbar mit einem Befestigungsteil, z. B. einem Kunststoffspritzteil, einem Federteil und / oder einem Gummiteil, an dem Gehäuse befestigt.

Das Gehäuse kann wenigstens teilweise, insbesondere vollständig, aus einem nicht ferromagnetischen Material, vorzugsweise Kunststoff, Edelstahl, Aluminium oder Messing, bestehen.

Die Sensoranordnung umfasst eine Elektronik, insbesondere einen Mikrokontroller, insbesondere zur Verarbeitung wenigstens einen Parameters des Teach-In-Elements. Zusammen mit der Elektronik ist aufgrund einer Veränderung des wenigstens einen Parameters bei einer Lageänderung des Targets, wenigstens ein Schaltzustand für die Kalibrierung des Sensors ausführbar.

Mittels der Elektronik wird wenigstens ein Parameter des Sensors und/oder des Zusatzsensors ausgewertet und/oder gespeichert. Hierzu umfasst die Elektronik im Allgemeinen auch eine Speichereinheit, mittels der Kalibrierdaten für den Sensor gespeichert werden können oder gespeichert sind. Die Elektronik kann dabei analoge oder digitale Ausgangssignale, insbesondere bezüglich eines Schaltzustandes des Sensors liefern und mittels dieser Ausgangssignale kann beispielsweise ein Schalter des Sensors von der Elektronik ein- und ausgeschaltet werden und/oder die Kalibrierung des Sensors ausgeführt werden.

Der Zusatzsensor ist hierbei mittels einer Veränderung eines elektromagnetischen Feldes berührungslos von dem Target betätigbar, wobei der Zusatzsensor vorzugsweise als ein Hallsensor oder ein induktiver Sensor ausgebildet ist

Der Zusatzsensor wird als Teach-In-Element aufgefasst, da von der Elektronik wenigstens ein Parameter des Zusatzsensors erfasst wird und mittels einer Auswertung dieses wenigstens einen Parameters des Zusatzsensors von der Elektronik für wenigstens zwei unterschiedliche Parameter wenigstens zwei unterschiedliche Schaltzustände zur Verfügung gestellt werden.

Insbesondere ist der Sensor ein Proximitysensor und / oder ein induktiver, kapazitiver, optischer oder magnetischer Sensor oder Ultraschallsensor. Mit dem Zusatzsensor als Teach-In-Element erfolgt die Kalibrierung des Sensors.

In einer ergänzenden Variante ist der Zusatzsensor mittels einer Veränderung eines elektromagnetischen Feldes betätigbar. Der Zusatzsensor kann ein Hallsensor oder ein induktiver Sensor sein. Der Zusatzsensor ist berührungslos von dem Target betätigbar. Der Zusatzsensor ist ein Proximitysensor ausgeführt.

In einer weiteren Variante umfasst die Sensoranordnung eine optische und / oder akustische Anzeigeeinrichtung. Mit der optischen und / oder akustischen Anzeigeeinrichtung kann somit dem Anwender der Sensoranordnung angezeigt werden, in welchem Kalibrierzustand bzw. Teach-In-Modus sich die Sensoranordnung befindet.

In einer weiteren Ausgestaltung besteht das Gehäuse wenigstens teilweise, insbesondere vollständig, aus einem nicht ferromagnetischen Material, z. B. Kunststoff, und / oder aus einem im Wesentlichen nicht ferromagnetischen Metall, z. B. Edelstahl, Aluminium oder Messing.

Mittels des Zusatzsensors kann somit durch das Gehäuse aus dem nicht ferromagnetischen Material bzw. Metall die Position des Targets außerhalb erfasst und dadurch der Zusatzsensor bzw. das Teach-In-Element betätigt werden.

Insbesondere umfasst die Sensoranordnung eine Energieversorgungseinrichtung, z. B. ein Stromkabel und / oder eine Batterie.

In einer weiteren Ausgestaltung sind der Sensor und der Zusatzsensor als Teach-In-Element gesonderte Bauteile. Der Zusatzsensor ist in dieser Ausgestaltung nicht von dem Sensor gebildet.

In einer zusätzlichen Ausführungsform ist der Sensor wenigstens teilweise, insbesondere vollständig, von dem Zusatzsensor gebildet oder umgekehrt, so dass der Sensor und der Zusatzsensor wenigstens teilweise, insbesondere vollständig, ein gemeinsames Bauteil sind.

Zweckmäßig sind die Komponenten des Sensors und des Zusatzsensors, nicht jedoch das Target, von dem Gehäuse, insbesondere vollständig, umschlossen und vorzugsweise ist das Gehäuse wenigstens teilweise von einer Vergussmasse gebildet. Beispielsweise sind somit die Komponenten des Sensors und des Zusatzsensors von der Vergussmasse umschlossen bzw. gekapselt und außerhalb der Vergussmasse ist das Gehäuse aus einem Kunststoffspritzgussteil ausgebildet.

In einer weiteren Ausgestaltung sind der Sensor und / oder der Zusatzsensor oder wenigstens eine Komponente des Sensors und / oder des Zusatzsensors ein SMD-Bauteil bzw. SMD-Bauteile (surface mounted device) Derartige SMD-Bauteile sind kompakt und können einfach auf bzw. mit einer Leiterplatte oder Platine mechanisch und elektrisch verbunden werden.

In einer ergänzenden Variante weisen der Sensor und der Zusatzsensor eine unterschiedliche Wirkrichtung auf. Beispielsweise stehen die Wirkrichtungen aufeinander senkrecht oder sind entgegensetzt gerichtet.

In einer zusätzlichen Ausführungsform sind unterschiedliche Teach-In-Zustände mittels der Dauer einer Annäherung des Targets an den Zusatzsensor und/oder mit einer vorgegebenen Anzahl von Wiederholungen der Annäherungen einstellbar.

In einer weiteren Ausgestaltung sind unterschiedliche Teach-In-Zustände mit der optischen und/oder akustischen Anzeigeeinrichtung anzeigbar. Beispielsweise können mit unterschiedlichen Blinkfrequenzen einer optischen Anzeigeeinrichtung unterschiedliche Teach-In-Zustände angezeigt werden.

Zweckmäßig ist der Sensor ein schaltender Sensor mit einem Schalter, wobei insbesondere bei wenigstens einem Einschalt-Bereich wenigstens eines Parameters des Sensors der Schalter geöffnet ist und bei wenigstens einem Ausschalt-Bereich des wenigstens einen Parameters der Schalter geschlossen ist. Vorzugsweise wird der wenigstens eine Parameter von der Elektronik ausgewertet, so dass eine Zuordnung zu dem Einschalt- oder Ausschalt-Bereich von der Elektronik ausführbar ist.

Zweckmäßig löst ein Bewegen des Targets ein akustisches Signal aus. Ist beispielsweise das Target von einem Federelement gebildet bedingt eine Bewegung des Federelementes ein Klickgeräusch. Dadurch kann beim Aufbringen einer Druckkraft auf das Federelement von dem Anwender das Betätigen des Federelementes nicht nur haptisch, sondern auch akustisch wahrgenommen werden.

Im Nachfolgenden werden Ausführungsbeispiele der Erfindung unter Bezugnahme auf die beigefügten Zeichnungen näher beschrieben. Es zeigt:
- Fig. 1: einen stark vereinfachten Schnitt einer Sensoranordnung,
- Fig. 2: einen stark vereinfachten Schnitt der Sensoranordnung in einem ersten Ausführungsbeispiel,
- Fig. 3: einen stark vereinfachten Schnitt der Sensoranordnung in einem zweiten Ausführungsbeispiel,
- Fig. 4: einen stark vereinfachten Schnitt der Sensoranordnung in einem dritten Ausführungsbeispiel,
- Fig. 5: einen stark vereinfachten Schnitt einer Sensoranordnung und
- Fig. 6: ein stark vereinfachtes Schaltbild der Sensoranordnung.

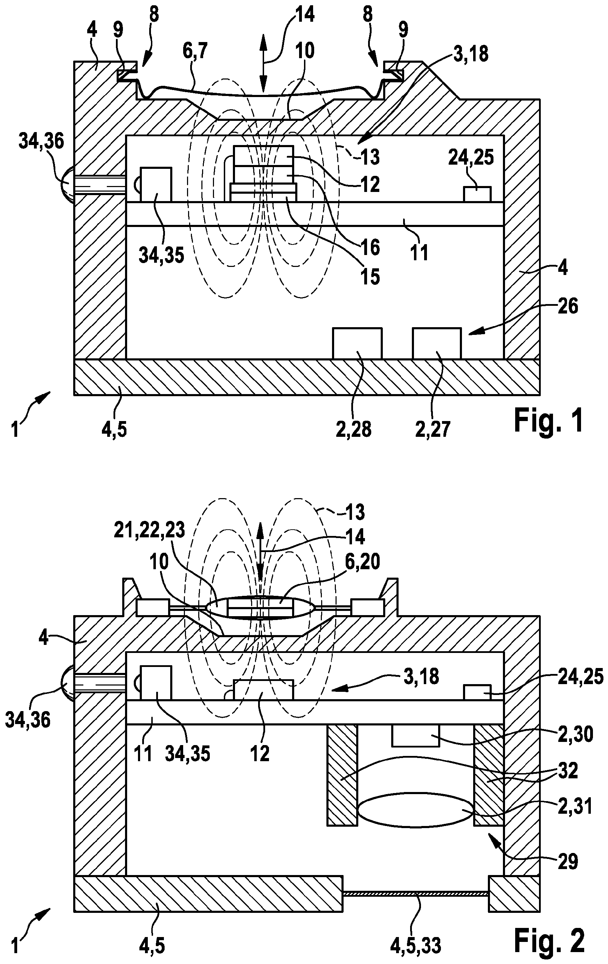

Eine in Fig.1 dargestellte Sensoranordnung 1 wird in den verschiedensten technischen Gebieten eingesetzt. Ein Sensor 2 ist beispielsweise ein Proximitysensor oder ein Füllstandssensor für eine technische Anwendung. Die Sensoranordnung 1 umfasst dabei neben dem Sensor 2 ein Gehäuse 4 und einen Zusatzsensor 3 als Teach-In-Element 3. Dabei sind sowohl der Sensor 2 als auch der Zusatzsensor 3 innerhalb des fluiddichten Gehäuses 4 mit einem Verschlussdeckel 5 angeordnet. Das Gehäuse 4, wobei das Gehäuse 4 den Verschlussdeckel 5 umfasst, ist dabei aus thermoplastischem Kunststoff mittels Spritzgießen hergestellt.

Der Zusatzsensor 3 innerhalb des Gehäuses 4 ist in Fig. 1 als ein Hallsensor 18 ausgebildet. Der Hallsensor 18 umfasst ein Hallelement 12, einen Abstandshalter 16 und einen Permanentmagneten 15 des Zusatzsensors 3. Der Abstandshalter 16 ist dabei zwischen dem Hallelement 12 und dem Permanentmagneten 15 angeordnet. Der Permanentmagnet 15 ist mechanisch mit einer Leiterplatte 11 verbunden und die Leiterplatte 11 ist ihrerseits an dem Gehäuse 4 befestigt. An der Leiterplatte 11 ist außerdem eine als Mikrocontroller 25 ausgebildete

Elektronik 24 angeordnet und außerdem eine LED 35. Das von der LED 35 erzeugte Licht wird durch einen in das Gehäuse 4 integrierten Lichtleiter 36 nach außerhalb des Gehäuses geleitet, so dass die LED 35 und der Lichtleiter 36 eine optische Anzeigeeinrichtung 34 bilden. Zweckmäßig wird dabei der Lichtleiter 36 beim Spritzgießen des Gehäuses 4 aus thermoplastischem Kunststoff umspritzt, beispielsweise besteht der Lichtleiter 36 aus temperaturbeständigem Glas. Mittels nicht dargestellter Stromleitungen auf der Leiterplatte 11 sind die LED 35, das Hallelement 12 und der Mikrocontroller 35 elektrisch miteinander verbunden und mittels einer nicht dargestellten Energieversorgungseinrichtung, z. B. einem durch das Gehäuse 4 fluiddicht geführten Stromkabel oder einer Batterie, werden die Komponenten des Sensors 2 und des Zusatzsensors 3 mit elektrischer Energie versorgt. Der Sensor 2 ist dabei ein induktiver Sensor 26 mit einer Spule 27, und einem Kondensator 28 die einen elektrischen Schwingkreis bilden. Außerdem umfasst der induktive Sensor 26 als Sensor 2 auch eine nicht dargestellte Anregungseinheit für den von der Spule 27 und dem Kondensator 28 gebildeten elektrischen Schwingkreis. Der Sensor 2 kann damit einen zu erfassenden Gegenstand (nicht dargestellt) aus einem ferromagnetischen Material, z. B. Eisen, außerhalb des Gehäuses 4 erfassen.

An der Außenseite des Gehäuses 4 ist ein als Federelement 7 ausgebildetes Target 6 lösbar mit dem Gehäuse 4 verbunden. Hierzu sind an dem Gehäuse 4 zwei Aussparungen 9 ausgebildet, innerhalb dessen das Federelement 7 mittels einer Clips- und Rastverbindung 8 befestigt ist. Das Federelement 7 besteht aus einem ferromagnetischen Material, z. B. Eisen. Ferner ist das Federelement 7 in Richtung einer Bewegungsrichtung 14 zwischen zwei Stellungen bewegbar. Wird auf das Federelement 7 von außen eine Druckkraft aufgebracht, bewegt sich der mittlere Teil des Federelementes 7 in Richtung zu dem Hallelement 12 und es tritt außerdem ein Klickgeräusch auf. Hier befindet sich das Federelement 7 in einer ersten Position oder Stellung.

Wird vom Anwender der Sensoranordnung 1 keine Druckkraft mehr auf das Federelement 7 aufgebracht, bewegt sich das Federelement 7 überwiegend im mittleren Bereich wieder von dem Hallelement 12 selbständig weg und wird aufgrund einer entsprechenden Vorspannung des Federelementes 7 und es tritt wiederum ein Klickgeräusch auf. In dieser von dem Hallelement 12 weiter entfernten Position bzw. Stellung des Federelementes 7 liegt somit eine zweite Position des Federelementes 7 vor. Der Permanentmagnet 15 des Zusatzsensors 3 als Hallsensor 18 erzeugt ein magnetisches Feld 13. Bei einer Bewegung des Federelementes 7 zwischen der ersten und zweiten Position oder Stellung wird dieses magnetische Feld 13 verändert und diese Veränderung des magnetischen Feldes 13 bedingt an dem Hallelement 12 eine andere Hallspannung. Diese Veränderung der Hallspannung wird von der Elektronik 24 erfasst und ausgewertet. Dadurch kann berührungslos mittels einer Veränderung des elektromagnetischen Feldes 13 durch das Bewegen des Federelementes 7 durch den Anwender der Teach-In-Element 3 zur Verfügung gestellt werden.

An dem Gehäuse 4 ist dadurch zwischen dem Federelement 7 und dem Hallelement 12 keine Durchführung eines Stromkabels erforderlich und mittels einer verminderten Wanddicke 10 des Gehäuses 4 kann das elektromagnetische Feld 13 die Wandung des Gehäuses 4 besonders einfach durchdringen. Durch das Aufbringen einer Druckkraft auf das Federelement 7 von außen und das Entfernen der Druckkraft von dem Federelement 7 kann das Federelement 7 zwischen zwei Schaltpositionen bewegt werden und diese beiden unterschiedlichen Schaltpositionen des Federelementes 7 können von dem Mikrocontroller 25 mittels des Hallelementes 12 erfasst werden und zur Kalibrierung des Sensors 2 eingesetzt werden. Die Wirkrichtung des Zusatzsensors 3 ist in Fig. 1 nach oben ausgerichtet und die Wirkrichtung des Sensors 2 nach unten ausgerichtet. Befindet sich somit gemäß der Darstellung in Fig. 1 ein von dem Sensor 2 erfassender Gegenstand unterhalb des Gehäuses 4 bzw. des Verschlussdeckels 5 kann für unterschiedliche Entfernungen dieses von dem Sensor 2 zu erfassenden Gegenstandes (nicht dargestellt) der Sensor 2 kalibriert werden. Unterschiedliche Kalibrierzustände können dabei von der optischen Anzeigeeinrichtung 34 von außerhalb des Gehäuses 4 angezeigt werden.

In Fig.2 ist ein erstes Ausführungsbeispiel der Sensoranordnung 1 dargestellt. Im Nachfolgenden werden im Wesentlichen nur die Unterschiede zu der Sensorvorrichtung 1 der Fig. 1 beschrieben. Der Sensor 2 ist ein optischer Sensor 29 mit einer Fotodiode 30 und einer Linse 31. Die Linse 31 ist mittels eines Linsenträgers 32 an dem Gehäuse 4 und an der Leiterplatte 11 befestigt. An dem Verschlussdeckel 5 des Gehäuses 4 ist eine Glasscheibe 33 integriert als Bestandteil des Gehäuses 4, so dass dadurch Licht von außen durch die Linse 31 auf die Fotodiode 30 gelangt. Zweckmäßig umfasst der optische Sensor 29 auch einen nicht dargestellten Lichtsender, z.B. einen Laser oder eine LED. Das Target 6 außerhalb des Gehäuses 4 ist als ein Permanentmagnet 20 ausgebildet. Der Permanentmagnet 20 ist dabei mittels eines Befestigungsteiles 21 stoffschlüssig, z.B. mittels Kleben, mit dem Gehäuse 4 verbunden. Das Befestigungsteil 21 ist ein Kunststoffspritzgussteil 22, das auch als ein Federteil 23 ausgebildet ist. Das Kunststoffspritzgussteil 22 umschließt den Permanentmagneten 20 vollständig und der Permanentmagnet 20 ist zwischen zwei Schaltpositionen bzw. Stellungen in analoger Weise wie das Federelement 7 gemäß der Figur 1 bewegbar. Wird von oben auf das Kunststoffspritzgussteil 22 eine Kraft aufgebracht, bewegt sich Permanentmagnet 20 zu einer ersten Schaltposition näher an dem Hallelement 12 und wird diese Druckkraft nicht mehr aufgebracht, bewegt sich der Permanentmagnet 20 selbständig zu einer zweiten Schaltposition in einer größeren Entfernung zu dem Hallelement 12. Aufgrund dieser Bewegung des Permanentmagneten 20 zwischen den beiden Schaltpositionen kommt es zu einer Veränderung des elektromagnetischen Feldes 13 an dem Hallelement 12, was eine Veränderung der Hallspannung an dem Hallelement 12 bedingt. Diese Veränderung der Hallspannung kann von dem Mikrocontroller 25 erfasst und ausgewertet werden und dadurch auch die Position des Targets 6 außerhalb des Gehäuses 4. Dadurch ist es möglich mittels eines Aufbringens einer Druckkraft und eines Bewegens des Permanentmagneten 20 zwischen zwei Schaltpositionen außerhalb des Gehäuses 4 das Teach-In-Element 3 zur Kalibrierung des Sensors 2 zur Verfügung zu stellen. Dabei erfolgt die Übertragung bzw. das Schalten des Teach-In-Elements 3 berührungslos zwischen dem Permanentmagneten 20 und dem Hallelement 12.

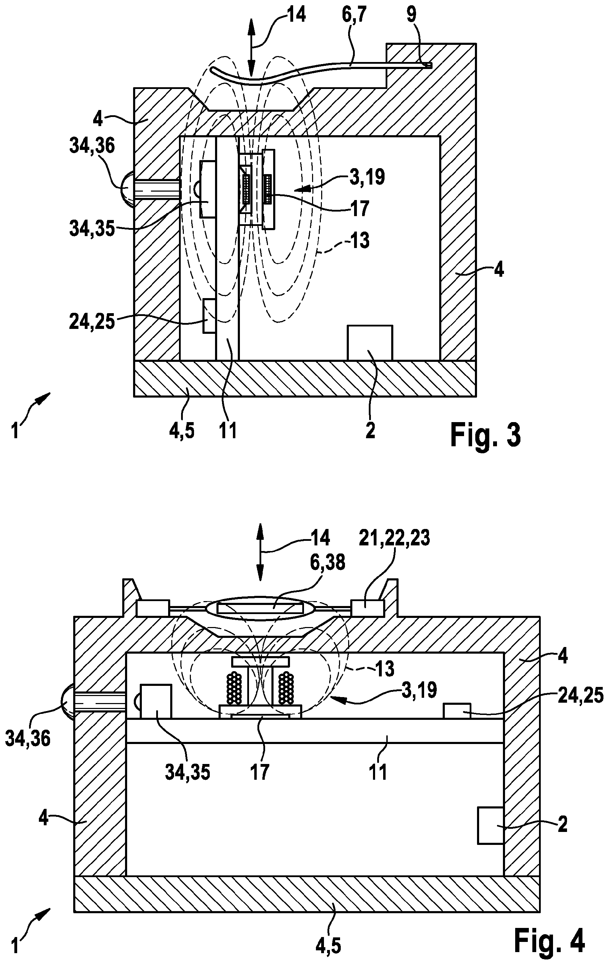

In Fig.3 ist ein zweites Ausführungsbeispiel der Sensoranordnung 1 dargestellt. Im Nachfolgenden werden im Wesentlichen nur die Unterschiede zu der Sensorvorrichtung 1 gemäß Fig.1 beschrieben. Der Zusatzsensor 3 innerhalb des Gehäuses 4 ist als ein induktiver Sensor 19 ausgebildet. Der induktive Sensor 19 umfasst eine Spule 17 und einen nicht dargestellten Kondensator, die einen nicht dargestellten elektrischen Schwingkreis bilden. Mittels dieses nicht dargestellten elektrischen Schwingkreises und einer Anregungseinheit (nicht dargestellt) zur Anregung des elektrischen Schwingkreises wird von der Spule 17 ein veränderliches elektromagnetisches Feld 13 erzeugt. Das Federelement 7 aus einem ferromagnetischen Material, z.B. Eisen, ist mittels einer Umspritzung an dem Gehäuse 4 aus thermoplastischem Kunststoff an dem Gehäuse 4 befestigt. Bei einer Bewegung des linken Endbereiches des Federelementes 7 mittels eines Aufbringens einer Druckkraft zwischen unterschiedlichen Schaltstellungen führt dies zu Veränderungen in dem elektromagnetischen Feld 13, was von der Elektronik 24 erfasst wird. Dadurch ist es möglich, mittels der Elektronik 24 bzw. dem Mikrocontroller 25 die beiden unterschiedlichen Schaltpositionen des Federelementes 7 außerhalb des Gehäuses 4 zu erfassen und dadurch den Sensor 2 zu kalibrieren.

In Fig.4 ist ein drittes Ausführungsbeispiel der Sensoranordnung 1 dargestellt. Im Nachfolgenden werden im Wesentlichen nur die Unterschiede zu dem zweiten Ausführungsbeispiel gemäß Fig.3 beschrieben. Das Target 6 ist als ein Eisenteil 38 ausgebildet, das von einem Befestigungsteil 21 als Kunststoffspritzteil 22 und Federteil 23 analog zu dem Ausführungsbeispiel gemäß Fig.2 umspritzt ist. Bei einer Bewegung des Eisenteiles 38 aufgrund eines Aufbringens einer Druckkraft auf das Befestigungsteil 21 wird das Eisenteil 38 in der Bewegungsrichtung 14 zwischen zwei Schaltpositionen bewegt und dies führt zu einer Veränderung des elektromagnetischen Feldes 13 des induktiven Sensors 19 als Zusatzsensor 3, das von dem Mikrocontroller 25 erfasst wird zur Kalibrierung des Sensors 2.

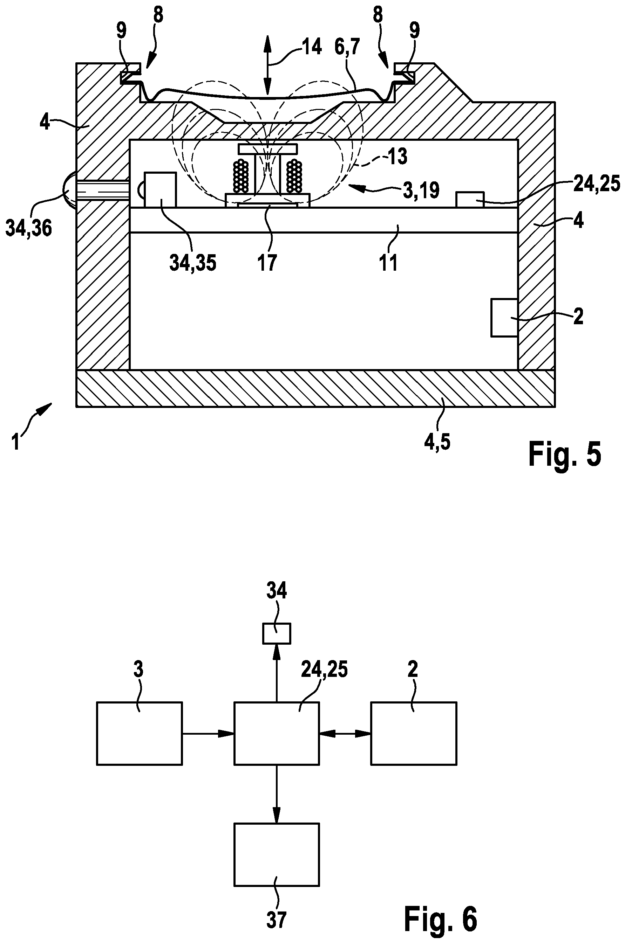

In Fig.5 ist eine Sensoranordnung 1 dargestellt. Im Nachfolgenden werden im Wesentlichen nur die Unterschiede zu dem zweiten Ausführungsbeispiel gemäß Fig.3 beschrieben. Das Target 6 ist als ein Federelement 7 gemäß Fig.1 ausgebildet. Das heißt, das Federelement 7 ist an zwei Enden mittels einer Clips- und Rastverbindung 8 mit dem Gehäuse 4 verbunden.

In Fig.6 ist ein stark vereinfachtes Schaltbild der Sensoranordnung 1 dargestellt. Von dem als Mikrocontroller 25 ausgebildeten Elektronik 24 wird wenigstens ein Parameter des Zusatzsensors 3, z.B. das Messen einer Impedanz der Spule 17 oder einer Hallspannung des Hallelementes 12, erfasst und hieraus ein Schaltzustand des Teach-In-Elements 3 bzw. eine Schaltstellung des Targets 6 ermittelt. Aufgrund dieses Parameters des Zusatzsensors 3 wird von dem Mikrocontroller 25 ein analoges oder digitales Signal bereitgestellt, welches die optische Anzeigeeinrichtung 34 schaltet. Dadurch kann der Teach-In-Status mittels der optischen Anzeigeeinrichtung 34 angezeigt werden. Außerdem wird von dem Mikrocontroller 25 wenigstens ein Parameter des Sensors 2 erfasst und ausgewertet, z.B. der von der Fotodiode 30 zur Verfügung gestellte Strom oder eine Veränderung der Impedanz der Spule 27 des Sensors 2. In Abhängigkeit dieses wenigstens einen Parameters des Sensors 2 wird mittels des Mikrocontrollers 25 ein Schalter (nicht dargestellt) des Sensors 2 aufgrund von digitalen oder analogen Signalen des Mikrocontrollers 25 angesteuert. Mittels der Kalibrierung der Sensoranordnung 1 können unterschiedliche Parameter des Sensors 2 unterschiedliche Schaltzustände des Schalters zugeordnet werden und dadurch kann eine Kalibrierung oder ein Teach-In der Sensoranordnung 1 ausgeführt werden. Darüber hinaus kann mit dem Mikrocontroller 25 ein Ausgangstreiber 27 des Sensors 2 mittels analoger oder digitaler Signale angesteuert werden. Der Ausgangstreiber 37 schaltet einen nicht dargestellten Schalter der Sensoranordnung 2 oder stellt entsprechende Steuersignale zur Steuerung von Vorrichtungen außerhalb der Sensoranordnung 1 zur Verfügung. Diese Vorrichtungen sind somit Vorrichtungen, welche von dem Sensor 2 angesteuert werden.

Insgesamt betrachtet sind mit der erfindungsgemäßen Sensoranordnung 1 wesentliche Vorteile verbunden. Das ein- oder mehrteilige Gehäuse 4 aus Kunststoff ist außenseitig mit einem Target 6 verbunden. Durch ein Bewegen des Targets 6 außerhalb des Gehäuses 4 kann ein Zusatzsensor 3 bzw. Teach-In-Element 3 berührungslos von außerhalb des Gehäuses 4 betätigt werden. Dadurch kann mittels einer Bewegung des Targets 6 der Sensor 2 berührungslos kalibriert werden, ohne dass es in aufwendiger Weise erforderlich ist, Stromkabel durch das Gehäuse 4 zu führen. Das Target 6 bildet somit ein außerhalb des Gehäuses 4 ausgebildetes mechanisches Betätigungsorgan, dessen Schaltposition mittels des Zusatzsensors 3 innerhalb des Gehäuses 4 berührungslos erfasst werden kann, so dass dadurch einerseits das Gehäuse 4 in der Herstellung besonders preiswert ist, weil beispielsweise keine fluiddichte Abdichtung von Stromleitungen durch das Gehäuse 4 erforderlich ist und andererseits braucht der Anwender der Sensoranordnung 1 beispielsweise keinen Schraubendreher außerhalb des Gehäuses 4 zur Betätigung oder Auslösung des Zusatzsensors 3 bzw. Teach-In-Elements3 vorhalten, da mittels des an dem Gehäuse 4 befestigten Targets 6 als mechanisches Betätigungsorgan der Teach-In-Element 3 geschalten werden kann als Bestandteil der Sensoranordnung 1.

### BEZUGSZEICHENLISTE

- 1: Sensoranordnung
- 2: Sensor
- 3: Zusatzsensor, Teach-In-Element
- 4: Gehäuse
- 5: Verschlussdeckel
- 6: Target
- 7: Federelement
- 8: Clips- und Rastverbindung
- 9: Aussparung an Gehäuse
- 10: Wanddicke
- 11: Leiterplatte
- 12: Hallelement des Zusatzsensors
- 13: Elektromagnetisches Feld des Zusatzsensors
- 14: Bewegungsrichtung des Targets
- 15: Permanentmagnet des Zusatzsensors
- 16: Abstandhalter des Zusatzsensors
- 17: Spule des Zusatzsensors
- 18: Hallsensor als Zusatzsensor
- 19: Induktiver Sensor als Zusatzsensor
- 20: Permanentmagnet als Target
- 21: Befestigungsteil
- 22: Kunststoffspritzgussteil
- 23: Federteil
- 24: Elektronik
- 25: Mikrokontroller
- 26: induktiver Sensor
- 27: Spule
- 28: Kondensator
- 29: optischer Sensor
- 30: Fotodiode
- 31: Linse
- 32: Linsenträgers
- 33: Glasscheibe
- 34: Anzeigeeinrichtung
- 35: LED
- 36: Lichtleiter
- 37: Ausgangstreiber
- 38: Eisenteil

## Patentansprüche

1. Sensoranordnung (1), umfassend ein Gehäuse (4), einen Sensor (2), einen Zusatzsensor (3) und ein Target (6),
wobei der Sensor (2) oder ein Teil des Sensors (2) innerhalb des Gehäuses (4) angeordnet ist, wobei der Zusatzsensor (3) innerhalb des Gehäuses (4) angeordnet ist und als Teach-In-Element (3) zur berührungslosen Kalibrierung des Sensors (2) ausgebildet ist, wobei das Target (6) außerhalb des Gehäuses(4) bewegbar ausgeführt ist; **dadurch gekennzeichnet, dass**
das Target mittelbar oder unmittelbar mittels einer Umspritzung oder einer Klebung fest mit dem Gehäuse (4) verbunden ist, so dass mit dem Target (6) der Zusatzsensor (3) als Teach-In-Element (3) mittels einer Bewegung des Targets (6) betätigbar ist.

2. Sensoranordnung nach Anspruch 1, **dadurch gekennzeichnet, dass** das Target (6) zwischen wenigstens zwei definierten Positionen bewegbar ausgeführt ist,
so dass in einer ersten Position des Targets (6) mittels des Teach-In-Elements (3) ein erster Schaltzustand realisierbar ist und in einer zweiten Position des Targets (6) ein zweiter Schaltzustand realisierbar ist, wobei die Schaltzustände zur Kalibrierung des Sensors (2) verwendbar sind.

3. Sensoranordnung nach einem oder mehreren der vorhergehenden Ansprüche, **dadurch gekennzeichnet, dass** die Sensoranordnung (1) eine Elektronik (24), insbesondere einen Mikrokontroller (25), umfasst, insbesondere zur Verarbeitung wenigstens einen Parameters des Teach-In-Elements (3) und / oder des Sensors (2).

4. Sensoranordnung nach Anspruch 3, **dadurch gekennzeichnet, dass** zusammen mit der Elektronik (24), aufgrund einer Veränderung des wenigstens einen Parameters bei einer Lageänderung des Targets (6), wenigstens ein Schaltzustand für die Kalibrierung ausführbar ist.

5. Sensoranordnung nach einem oder mehreren der vorhergehenden Ansprüche, **dadurch gekennzeichnet, dass** das Target (6) mit einer form- und / oder stoff- und / oder kraftschlüssigen Verbindung mit dem Gehäuse (4) verbunden ist.

6. Sensoranordnung nach einem oder mehreren der vorhergehenden Ansprüche, **dadurch gekennzeichnet, dass** der Zusatzsensor (3) mittels einer Veränderung eines elektromagnetischen Feldes (13) berührungslos von dem Target (6) betätigbar ist, wobei der Zusatzsensor (3) vorzugsweise als ein Hallsensor (18) oder ein induktiver Sensor (19) ausgebildet ist.

7. Sensoranordnung nach einem oder mehreren der vorhergehenden Ansprüche, **dadurch gekennzeichnet, dass** die Sensoranordnung (1) eine optische und / oder akustische Anzeigeeinrichtung (34) zur Anzeige des jeweiligen Schaltzustandes umfasst.

8. Sensoranordnung nach einem oder mehreren der vorhergehenden Ansprüche, **dadurch gekennzeichnet, dass** das Gehäuse (4) wenigstens teilweise, insbesondere vollständig, aus einem nicht ferromagnetischen Material, vorzugsweise Kunststoff, Edelstahl, Aluminium oder Messing, besteht.

9. Sensoranordnung nach einem oder mehreren der vorhergehenden Ansprüche, **dadurch gekennzeichnet, dass** der Sensor (2) und der Zusatzsensor (3) als Teach-In-Element (3) gesonderte Bauteile sind.

10. Sensoranordnung nach einem der vorhergehenden Ansprüche **dadurch gekennzeichnet, dass** das Target (6) ein biegbares Federelement (7) ist und vorzugsweise wenigstens teilweise aus einem ferromagnetischen Material besteht.

11. Sensoranordnung nach einem der Ansprüche 1 bis 9, **dadurch gekennzeichnet, dass** das Target (6) ein Permanentmagnet (20) ist und mittelbar mit einem Befestigungsteil (21), vorzugsweise einem Kunststoffspritzteil (22), einem Federteil (23) und / oder einem Gummiteil, an dem Gehäuse (4) befestigt ist.

## Claims

1. Sensor arrangement (1) comprising a housing (4), a sensor (2), an additional sensor (3) and a target (6),
whereby the sensor (2) or a part of the sensor (2) is located within the housing (4), whereby the additional sensor (3) is located within the housing (4) and is designed as a teach-in element (3) for the contact-free calibration of the sensor (2), whereby the target (6) is designed to be movable outside the housing (4); **characterized in that** the target is permanently connected directly or indirectly to the housing (4) by means of molding or a bonded joint, so that with the target (6) the additional sensor (3) can be actuated as a teach-in element (3) by means of a movement of the target (6).

2. Sensor arrangement in accordance with Claim 1, **characterized in that** the target (6) is designed to be movable between at least two defined positions,
so that in a first position of the target (6) a first switching state is possible by means of the teach-in element (3) and in a second position of the target (6) a second switching state is possible, whereby the switching states can be used for the calibration of the sensor (2).

3. Sensor arrangement in accordance with one or more of the preceding Claims, **characterized in that** the sensor arrangement (1) comprises an electronic system (24), in particular a micro controller (25), in particular for processing at least one parameter of the teach-in element (3) and / or of the sensor (2).

4. Sensor arrangement in accordance with Claim 3, **characterized in that** together with the electronic system (24), on account of a change in the at least one parameter in case of a change in position of the target (6), at least one switching state can be executed for the calibration.

5. Sensor arrangement in accordance with one or more of the preceding Claims, **characterized in that** the target (6) is connected to the housing (4) by means of a positive and / or substance-to-substance and / or frictional connection.

6. Sensor arrangement in accordance with one or more of the preceding Claims, **characterized in that** the additional sensor (3) can be contactlessly actuated by the target (6) by means of a change in an electromagnetic field (13), whereby the additional sensor (3) is preferably designed as a Hall sensor (18) or an inductive sensor (19).

7. Sensor arrangement in accordance with one or more of the preceding Claims, **characterized in that** the sensor arrangement (1) comprises an optical and / or acoustic display device (34) for indicating the switching state.

8. Sensor arrangement in accordance with one or more of the preceding Claims, **characterized in that** the housing (4) consists, at least partially, in particular completely, of a non-ferromagnetic material, preferably plastic, stainless steel, aluminum or brass.

9. Sensor arrangement in accordance with one or more of the preceding Claims, **characterized in that** the sensor (2) and the additional sensor (3) as a teach-in element (3) are separate components.

10. Sensor arrangement in accordance with any one of the preceding Claims, **characterized in that** the target (6) is a flexible spring element (7) and preferably consists, at least partially, of a ferromagnetic material.

11. Sensor arrangement in accordance with any one of Claims 1 to 9, **characterized in that** the target (6) is a permanent magnet (20), and is indirectly attached to the housing (4) with an attachment part (21), preferably a plastic molded part (22), a spring part (23) and / or a rubber part.

## Revendications

1. Agencement de détecteurs (1), comprenant un boîtier (4), un détecteur (2), un détecteur supplémentaire (3) et une cible (6),
le détecteur (2) ou une partie du détecteur (2) étant disposé à l'intérieur du boîtier (4), le détecteur supplémentaire (3) étant disposé à l'intérieur du boîtier (4) et se présentant sous la forme d'un élément Teach-In (3) pour le calibrage sans contact du détecteur (2), la cible (6) se présentant de manière mobile à l'extérieur du boîtier (4) ; **caractérisé en ce que** la cible est fixée à demeure au boîtier (4), directement ou indirectement, au moyen d'une extrusion ou d'un collage, de sorte qu'avec la cible (6) le détecteur supplémentaire (3) est actionnable en tant qu'élément Teach-In (3) au moyen d'un déplacement de la cible (6).

2. Agencement de détecteurs selon la revendication 1, **caractérisé en ce que** la cible (6) se présente de manière mobile entre au moins deux positions définies,
de telle sorte que dans une première position de la cible (6), un premier état de commutation est réalisable au moyen de l'élément Teach-In (3) et dans une seconde position de la cible (6), un second état de commutation est réalisable, les états de commutation étant utilisables pour calibrer le détecteur (2).

3. Agencement de détecteurs selon l'une ou plusieurs des revendications précédentes, **caractérisé en ce que** l'agencement de détecteurs (1) comprend un système électronique (24), en particulier un microcontrôleur (25), notamment pour traiter au moins un paramètre de l'élément Teach-In (3) et/ou du détecteur (2).

4. Agencement de détecteurs selon la revendication 3, **caractérisé en ce qu'**au moins un état de commutation est réalisable pour le calibrage avec le système électronique (24), en raison d'une modification du au moins un paramètre en cas de changement de position de la cible (6).

5. Agencement de détecteurs selon l'une ou plusieurs des revendications précédentes, **caractérisé en ce que** la cible (6) est raccordée au boîtier (4) par complémentarité de formes et/ou liaison de matière et/ou à force.

6. Agencement de détecteurs selon l'une ou plusieurs des revendications précédentes, **caractérisé en ce que** le détecteur supplémentaire (3) est actionnable sans contact par la cible (6) au moyen d'une modification d'un champ électromagnétique (13), le détecteur supplémentaire (3) se présentant de préférence sous la forme d'un détecteur Hall (18) ou d'un détecteur inductif (19).

7. Agencement de détecteurs selon l'une ou plusieurs des revendications précédentes, **caractérisé en ce que** l'agencement de détecteurs (1) comprend un dispositif de signalisation optique et/ou acoustique (34) pour signaler chaque état de commutation.

8. Agencement de détecteurs selon l'une ou plusieurs des revendications précédentes, **caractérisé en ce que** le boîtier (4) est constitué au moins partiellement, en particulier totalement, d'un matériau non ferromagnétique, de préférence du plastique, de l'acier inoxydable, de l'aluminium ou du laiton.

9. Agencement de détecteurs selon l'une ou plusieurs des revendications précédentes, **caractérisé en ce que** le détecteur (2) et le détecteur supplémentaire (3) en tant qu'élément Teach-In (3) sont des composants séparés.

10. Agencement de détecteurs selon l'une des revendications précédentes **caractérisé en ce que** la cible (6) est un élément de suspension (7) et est constitué de préférence, au moins partiellement, d'un matériau ferromagnétique.

11. Agencement de détecteurs selon l'une des revendications 1 à 9, **caractérisé en ce que** la cible (6) est un aimant permanent (20) et est fixée directement sur le boîtier (4) avec une pièce de fixation (21), de préférence une pièce moulée en plastique (22), une pièce de ressort (23) et/ou une pièce en caoutchouc.
